# EUROPEAN PATENT APPLICATION

(11) **EP 3 944 459 A1**
(43) Date of publication of application: **26.01.2022**
(21) Application number: 21186139.8
(22) Date of filing: 16.07.2021
(51) Int. Cl.: H02J 9/00, H05K 7/14

(54) **MODULAR UNINTERRUPTIBLE POWER SUPPLY SYSTEM**

(30) Priority: 16.07.2020 DE 202020104116 U
(71) Applicant: ABB Schweiz AG, 5400 Baden (CH)
(72) Inventor: COGLIATI, Matteo, 28811 Arizzano - Verbania (IT)
(74) Representative: Zimmermann & Partner Patentanwälte mbB

(57) **Abstract**

It is provided a modular uninterruptible power supply system including a separable uninterruptible power supply module and a system frame. It is further provided a method of operating a modular uninterruptible power supply system.

## Description

### TECHNICAL FIELD

The present invention relates to modular uninterruptible power supply (UPS) systems. According to embodiments, a modular uninterruptible power supply system is provided. According to embodiments, a method of operating a modular uninterruptible power supply system is provided.

### BACKGROUND

Modular uninterrupted power supply (UPS) systems typically have a central system level hardware for connecting the UPS systems to a power distribution, for which uninterrupted operation is to be achieved. The system level hardware may include customer cable landings, bypasses, switch gears, system user interfaces and so on. This system level hardware can be provided in an input/output (I/O) enclosure.

Typically, the UPS system further comprises at least one, usually multiple uninterrupted power supply modules. The UPS module can generate electrical power from a power source such as a battery. Such power can be transferred via an I/O connection enclosure to a power distribution network. To this purpose, an uninterrupted power supply module typically includes at least one converter. Number, size and power rating of the converters are chosen depending on the UPS system design based on customer requirements.

The UPS modules can be arranged in single, free standing enclosures, which are connected in parallel for providing power of at least tens of kilowatt. Accordingly, the UPS modules can be provided in the enclosures side by side to each other and connected by a busbar, which enables formation of high power UPS systems. The UPS modules can typically be installed or connected to the busbar by simply sliding them into such enclosures of the UPS system.

Document WO 2015/128253 A1 describes a docking frame for receiving at least one uninterrupted power supply module for high power uninterrupted power supply systems, typically with a power of at least tens of kilowatt, preferably a power of at least one hundred kilowatt, comprising connection means for electrically connecting the uninterrupted power supply module horizontally to at least another docking frame and/or an I/O module, wherein the connection means comprises at least one bus connection means for providing the electrical connection to the at least another docking frame and/or the I/O module.

Document WO 2015/128253 A1 further describes an uninterrupted power supply module for connection with the above docking frame and an uninterrupted power supply system comprising an I/O module for electrically connecting the uninterrupted power supply system, at least one above docking frame for receiving at least one above uninterrupted power supply module, whereby the I/O module and the at least one docking frame are provided in a horizontal arrangement.

There is an increasing demand for UPS modules with higher power ratings to provide larger UPS power capabilities. In such systems, a single UPS module with power ratings of 50 kW can weigh 60 kg to 70 kg, while bigger power modules with ratings of 250 kW can weigh 350 kg. In addition to the weight of the modules themselves, a single electrical contact can involve insertion and extraction forces in excess of 50 N. For bigger power modules, total insertion and extraction forces can exceed 500 N.

Accordingly, the installation, servicing, modification, removal and other operations of such large UPS modules can be a challenge and impossible for a single operator. For example, an adaptation due to changed power requirements, resulting in an addition, removal or substitution of converters, can be a rather complicated, labour intensive and difficult operation. Thus, there is a need to improve modular UPS systems, in particular for addressing the difficult handling requirements of large UPS modules.

### SUMMARY

In view of the above, a modular uninterruptible power supply system is provided.

The modular uninterruptible power supply system includes a separable uninterruptible power supply module with a first plurality of electrical contacts, the first plurality of electrical contacts comprising at least a set of first power contacts and a first protective earthing contact.

The modular uninterruptible power supply system includes a system frame.

The system frame includes-a receiving portion for receiving the separable uninterruptible power supply module therein, wherein the separable uninterruptible power supply module is insertable by an insertion-sliding motion into the receiving portion and removable by a removing-sliding motion out of the receiving portion, the removing sliding motion being opposite of the insertion sliding motion.

The system frame includes a second plurality of electrical contacts, the second plurality of electrical contacts comprising at least a set of second power contacts for electrically connecting with the set of first power contacts, and a second protective earthing contact for electrically connecting with the first protective earthing contact.

One of the set of first power contacts and the set of second power contacts are movable contacts, and the other one of the set of first power contacts and the set of second power contacts are fixed contacts.

The movable contacts are movable between an extended position and a retracted position.

When the separable uninterruptible power supply module is inserted into the receiving portion and when the movable contacts are in the extended position, the set of first power contacts are in electrical contact with the set of second power contacts.

When the separable uninterruptible power supply module is inserted into the receiving portion and when the movable contacts are in the retracted position, the set of first power contacts are electrically separated from the set of second power contacts.

Thus, according to aspects of the invention, the separable uninterruptible power supply module can be fixed to the system frame (receiving portion) (or added/inserted to the modular UPS system) with at least the first power contacts, and at least the second power contacts, separated from each other.

That is, the separable uninterruptible power supply module can be fixed to the system frame independently from connecting the first power contacts and second power contacts.

This connection can be established independently and in a well-defined manner, by another motion of the movable contacts. Accordingly, the force for connecting at least the first power contacts and second power contacts can be better controlled.

Thus, the insertion/removal into the receiving portion and connection/disconnection of power contacts may be facilitated and safety may be improved.

Further aspects, advantages and features of the present disclosure are apparent from the description and the accompanying drawings.

### BRIEF DESCRIPTION OF THE DRAWINGS

So that the manner in which the above recited features of the present disclosure can be understood in more detail, a more particular description of the disclosure, briefly summarized above, may be had by reference to the accompanying drawings which are briefly described as follows:
FIG. 1 shows a schematic drawing illustrating a separable uninterruptible power supply module according to embodiments described herein;
FIG. 2 shows a schematic diagram illustrating a modular uninterruptible power supply system according to embodiments described herein;
FIG. 3 shows a schematic diagram illustrating a plurality of fixed and movable contacts according to embodiments described herein;
FIG. 4A shows an illustration of a separable uninterruptible power supply module where the movable contacts are in an retracted position according to embodiments described herein;
FIG. 4B shows an illustration of a separable uninterruptible power supply module where the movable contacts are in a extended position according to embodiments described herein;
FIG. 5A shows an illustration of a separable uninterruptible power supply module where the movable power contacts are in an extended position according to embodiments described herein;
FIG. 5B shows an illustration of a separable uninterruptible power supply module where the movable power contacts are in an retracted position according to embodiments described herein;
FIG. 6 shows an illustration of a method of operating a modular uninterruptible power supply system according to embodiments described herein;
FIG. 7A shows an illustration of a method of operating a modular uninterruptible power supply system according to embodiments described herein; and
FIG. 7B shows an illustration of a method of operating a modular uninterruptible power supply system according to embodiments described herein.

### DETAILED DESCRIPTION OF EMBODIMENTS

Reference will now be made in detail to the various embodiments, one or more examples of which are illustrated in each figure. Each example is provided by way of explanation and is not meant as a limitation. For example, features illustrated or described as part of one embodiment can be used on or in conjunction with any other embodiment to yield yet a further embodiment. It is intended that the present disclosure includes such modifications and variations. Within the following description of the figures, the same reference numbers refer to the same or to similar components.

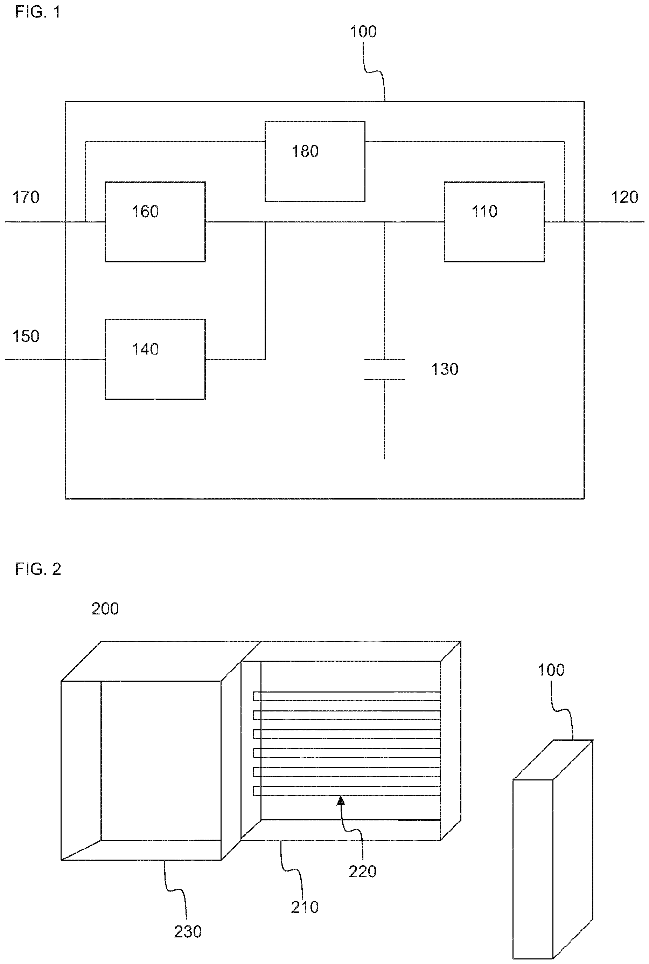

FIG. 1 shows a schematic drawing illustrating a separable uninterruptible power supply (UPS) module according to embodiments described herein. FIG. 1 shows a UPS module 100 and elements possibly comprised therein and their electrical connections to each other: a first converter 110, an external load 120, an internal DC link 130, a second converter 140, a first source of energy 150, an optional third converter 160, and a second source of energy 170. In embodiments, the UPS module may, in addition to the elements shown in Fig. 1, have further elements commonly used in a UPS module, such as, for example, at least one bypass. In embodiments, some elements may be omitted so that only a subset of the shown elements may be provided.

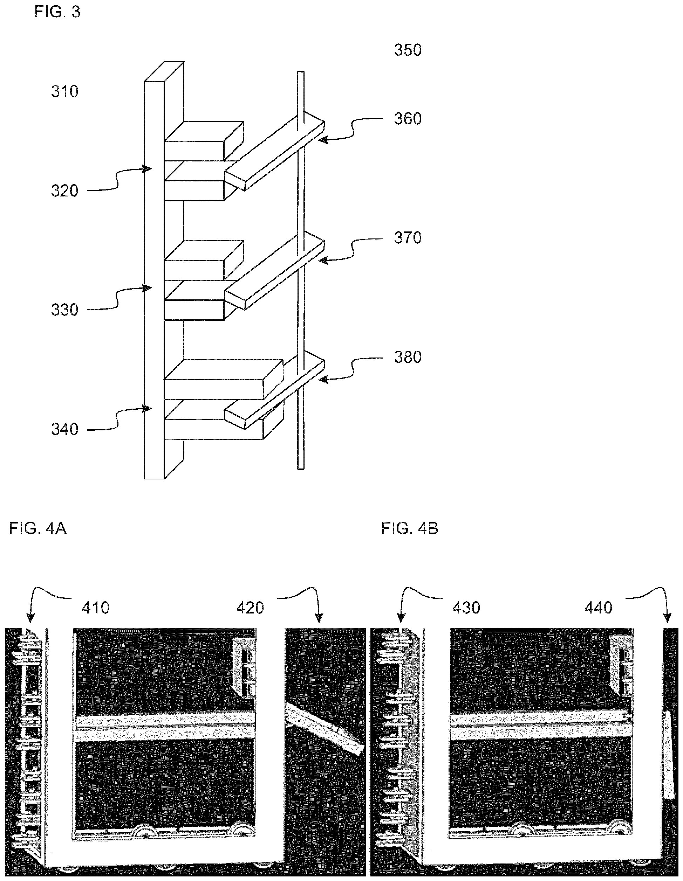

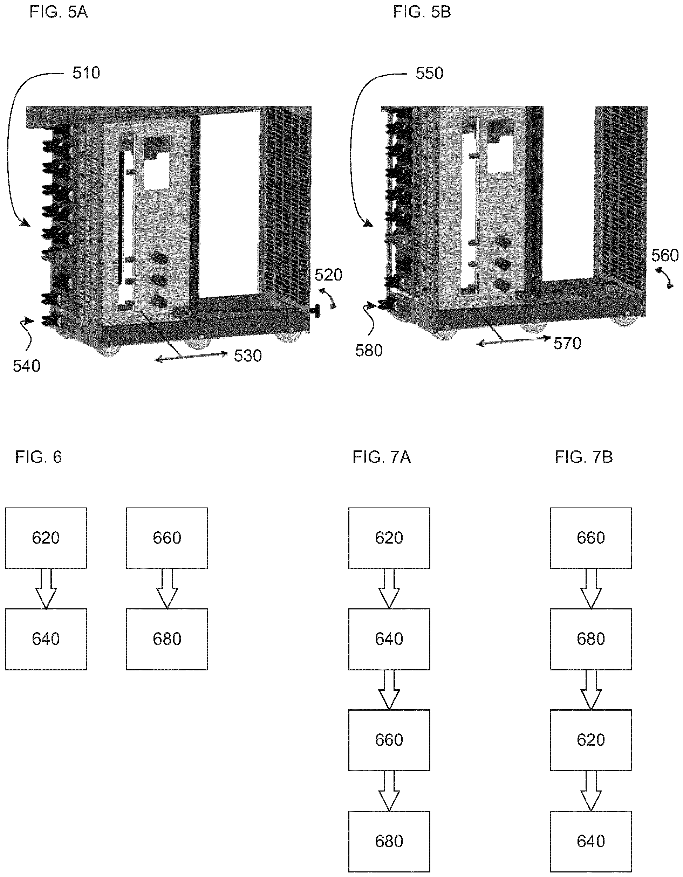

FIG. 2 shows a schematic diagram illustrating a modular uninterruptible power supply system according to embodiments described herein. FIG. 2 shows a modular UPS system including system frame 200, a receiving portion 210, busbars 220, a frame portion 230, and a UPS module 100. Here, the UPS module 100 may be for example the UPS module as described with respect to Fig. 1. The UPS module may be equipped with movable power contacts as shown in FIGS. 4A, 4B, 5A 5B, the movable power contacts facing the system frame 200.

FIG. 3 shows a schematic diagram illustrating a plurality of fixed and movable contacts according to embodiments described herein. FIG. 3 shows a plurality of fixed contacts 310 including a first fixed contact 320, a second fixed contact 330, and a third fixed contact 340, as well as a plurality of movable contacts 350 including a first movable contact 360, a second movable contact 370 and a third movable contact 380. For example, the fixed contacts 310, 320, 330 may be first power contacts belonging to the UPS module, and the movable contacts 360, 370, 380 may be second power contacts belonging to the system frame, or vice versa. The fixed contacts 320, 330, 340 are electrically isolated from each other and connected to respective phase conductors (power conductors) of the UPS module (or of the system frame). Likewise, the movable contacts 360, 370, 380 are electrically isolated from each other and connected to respective phase conductors (power conductors) (e.g., busbars) of the system frame (or of the UPS module). In particular, a lever operating or connecting the movable contacts 360, 370, 380 is electrically isolating. In an alternative embodiment (not shown), individual levers may be provided, one for each contact and/or for two or more contacts of a plurality of contacts.

FIG. 4A shows an illustration of a separable uninterruptible power supply module where the movable contacts are in a retracted position according to embodiments described herein. In the illustration, the movable contacts 410 which are operable by lever 420 are in a retracted position. In this example, the protective earthing contact (the bottom contact) is one of the movable contacts.

FIG. 4B shows an illustration of a separable uninterruptible power supply module where the movable contacts are in an extended position according to embodiments described herein. In the illustration, the movable contacts 430 which are operable by lever 440 are in an extended position. In this example, the protective earthing contact (the bottom contact) (of the UPS module) is a movable contact.

FIG. 5A shows an illustration of a separable uninterruptible power supply module where the movable power contacts are in an extended position according to embodiments described herein. In the illustration, the power contacts 510 are movable contacts operable by lever 520. The movable contacts are movable relative 530 to the UPS module. The movable power contacts 510 are shown in an extended position. In this example, the protective earthing contact 540 (of the UPS module) is a fixed contact and therefore does not move with the power contacts 510.

FIG. 5B shows an illustration of a separable uninterruptible power supply module where the movable power contacts are in a retracted position according to embodiments described herein. In the illustration, the power contacts 550 are movable contacts operable by lever 560. The movable contacts are movable relative 570 to the UPS module. The movable power contacts 510 are shown in a retracted position. In this example, the protective earthing contact 580 (of the UPS module) is a fixed contact and therefore does not move with the power contacts 550.

Next, further optional aspects of the invention are described. Each of these aspects can be combined with any other aspect or embodiment.

### Modular UPS

Uninterruptible Power Supply (UPS) systems may be distinguished as non-modular e.g. stand-alone or modular. In embodiments described herein, a modular UPS system is described.

In modular UPS systems, UPS modules are typically inserted into a system frame. The system frame may have wiring for power and control. There is increasing demand for modular UPS systems with larger power ratings and smaller footprints.

One approach to providing a UPS system with larger power ratings is to provide UPS modules with larger power ratings. The larger the power rating of a module, the bigger the dimensions of the module and the heavier the module becomes.

Accordingly, UPS modules with bigger dimensions and increasing weight causes increasing handling difficulty and movement control of the UPS module. Accordingly, a single operator may not be able to handle or control the movement of the UPS module. Handling and movement control is important for operations such as addition or removal of a UPS module into a UPS system.

According to an embodiment, the separable uninterruptible power supply module 100 is rated at least 50 kW and/or the separable uninterruptible power supply module 100 is at least 60kg.

A single UPS module of a small or medium power rating, for example up to 50 kW, may weigh up to 60 kg or 70kg. The weight of such a UPS module and the associated forces for insertion and connection of such a UPS module can be sufficiently manageable such that a single operator can handle the module without special arrangements.

A single UPS module of a higher power rating, for example from 250 kW, may weigh in excess of 350 kg. Accordingly, the weight of such a heavy UPS module and the associated forces for insertion and connection are too much for a single operator to manage.

Even when sufficient force can be exerted, e.g. with more operators or special equipment, the insertion of a single module weighing in excess of 350 kg directly onto the electrical contacts can easily cause damage to the contacts.

In addition to the weight, the connection and disconnection forces are also an issue. A single pole electrical power contact can require an insertion force or extraction force of at least 50 N. Accordingly, for a higher power rated module, with a plurality of power contacts, the total insertion force or extraction force required can very well be upwards of 500 N. Thus, the connection and disconnection forces can involve unacceptable equipment and safety issues.

Accordingly, a modular UPS system is provided by embodiments described herein addressing above issues. In particular, it is provided a UPS module that can be handled by a single operator even when the UPS module is particularly heavy or when the connection and disconnection forces involved are particularly large.

Accordingly, modular UPS systems with larger power ratings can be provided. Accordingly, at least one of handleability, serviceability and installation of the modular UPS system is improved.

### UPS module

A separable uninterruptible power supply module (100) or UPS module (100) is described in embodiments herein. A UPS module may include any number of components according to the required application. A plurality of UPS module may be provided, each with the same or different configurations. Accordingly, a flexible and customisable modular UPS system can be provided.

In the embodiment shown in FIG. 1, the UPS module 100 includes a first converter 110. The first converter 110 may be for supporting an external load 120. The first converter 110 may be connected on one side to the external load 120. The first converter 110 may be connected on another side to an internal DC link 130. In the embodiment shown in FIG. 1, the UPS module 100 includes the internal DC link 130.

In the embodiment shown in FIG. 1, the UPS module 100 includes a second converter 140. The second converter 140 may be of supporting a first source of energy 150. The first source of energy 150 may be a source of DC power, such as (but not limited to) a battery system. The first source of energy 150 may be single phase AC, multiphase AC, two or more pole DC or a combination thereof.

The second converter 140 may be connected on one side to the first source of energy 150. The second converter 140 may be connected on another side to the internal DC link 130.

In FIG. 1, the UPS module 100 does not include the first source of energy 150. For example, the first source of energy 150 may be provided as a separate module, e.g. a second UPS module (not shown). The UPS module 100 may be connected to a first source of energy 150 which is provided in a separate module via a system frame (shown in FIG. 2). Alternatively, the UPS module 100 may include the first source of energy 150 (not shown in FIG. 1).

Alternatively, there may be a plurality of the first source of energy 150, and the UPS module 100 may include at least one of the plurality of first source of energy 150 and at least another one of the plurality of first source of energy 150 may be provided in a separate module.

In the embodiment shown in FIG. 1, the UPS module 100 includes a third converter 160. The third converter 160 may be for supporting a second source of energy 170. The second source of energy 170 may be an AC mains supply. The second source of energy 170 may be single phase AC, multiphase AC, two or more pole DC or a combination thereof. Accordingly, an online UPS module 100 may be provided.

Alternatively, the UPS module 100 may not include the third converter 160. Accordingly, an offline UPS module may be provided. Alternatively, or in addition, different component(s) such as surge protector and/or filter may be provided. The UPS module may also be configured as a line interactive UPS module.

The separable UPS module or modular UPS system may include a bypass, e.g., for bypassing the DC link, for bypassing the UPS module, and/or for connecting a source of AC energy to load without intermediate DC stage. The separable UPS module or modular UPS system may include a controllable bypass switch.

The controllable bypass switch may selectively activate the bypass by connecting the (AC) source of energy 170 and/or an AC supply to the external load 120. Accordingly, the UPS system can be configured for bypassing a UPS module that is to be serviced, removed, replaced or in any other way bypassed.

The separable UPS module may include a fourth converter 180. The fourth converter 180 may be for providing a dual AC input function. The fourth converter 180 may be known as an AC bypass converter.

The UPS module may be of a high power rating. For example, the UPS module may be of a power rating of at least 50 kW, at least 100 kW, at least 150 kW, at least 200 kW or at least 250 kW. The UPS module may be rated up to 1000 kW, up to 800 kW, or up to 500 kW.

For example, the UPS module may be of a power rating of 50 kW to 1000 kW, 100 kW to 1000 kW, 150 kW to 1000 kW, 200 kW to 1000 kW, 250 kW to 1000 kW, 50 kW to 800 kW, 50 kW to 500 kW, 100 kW to 800 kW, 100 kW to 500 kW, 150 kW to 800 kW, 150 kW to 500 kW, 200 kW to 800 kW, 200 kW to 500 kW, 250 kW to 800 kW or 250 kW to 500 kW.

The UPS module may weigh at least 60kg, at least 100 kg, at least 150 kg, at least 200 kg, at least 250 kg, at least 300 kg, or at least 350 kg.

The UPS module may be on castors or wheels. Accordingly, the UPS module may be handled by a single operator.

### Contacts

According to embodiments, the modular UPS system includes a UPS module. According to embodiments, the UPS module includes a first plurality of electrical contacts. According to embodiments, the first plurality of electrical contacts includes at least a set of first power contacts and a first protective earthing contact.

According to embodiments, the modular UPS system includes a system frame. According to embodiments, the modular UPS system or the system frame includes a second plurality of electrical contacts. According to embodiments, the second plurality of electrical contacts includes at least a set of second power contacts for electrically connecting with the set of first power contacts, and a second protective earthing contact for electrically connecting with the first protective earthing contact.

According to embodiments, one of the first plurality of electrical contacts and the second plurality of electrical contacts are movable contacts, and the other one of the first plurality of electrical contacts and the second plurality of electrical contacts are fixed contacts.

The fixed contacts, in the case of the first plurality of electrical contacts, may be rigidly connected to the power supply module. Thus, the term "fixed contacts" implies a fixed connection to the respective entity, but does not exclude that the fixed contacts move jointly with the power supply module, e.g., when the power supply module is inserted into the receiving portion.

The fixed contacts, in the case of the second plurality of electrical contacts, may be rigidly connected to the system frame or the receiving portion of the system frame. Thus, the term "fixed contacts" implies a fixed connection to the respective entity.

According to embodiments, the movable contacts are movable between an extended position and a retracted position. According to embodiments, the UPS module can be inserted into a receiving portion.

According to embodiments, when the movable contacts are in the extended position, the set of first power contacts are in electrical contact with the set of second power contacts. According to embodiments, when the movable contacts are in the retracted position, the set of first power contacts are electrically separated from the set of second power contacts.

In some embodiments, the contacts, e.g. first plurality of electrical contacts, second plurality of electrical contacts, movable contacts, fixed contacts, are self-aligning, blind mateable, and/or floating contacts. Accordingly small misalignments can be tolerated.

### Lever

According to embodiments, the movable contacts are configured to be operable by a lever for moving the movable contacts between the retracted and the extended position.

In some embodiments, the contact can be operated via a lever to reduce force required for an insertion or extraction operation, preferably sufficiently such that it can be handled by a single person or operator.

A lever can be provided for moving a movable contact or plurality of movable contacts. Accordingly, a lever can reduce the force for operating a movable contact or a plurality of movable contacts. A lever may be operable by an operator, in particular by a single operator. A lever may be configured for connecting or disconnecting at least one electrical contact.

A lever can be provided with handle. A lever may be provided on a different side of a UPS module to a side of the UPS module provided with the movable contact(s), for example on an opposite side of the UPS module to the side of the UPS module with the movable contact(s).

According to embodiments, the movable contacts are operable by a single lever. Alternatively, the movable contacts may be operable by a plurality of levers. For example, the movable protective earthing contact is operable by a first lever and the movable power contacts are operable by at least a second lever.

The levers may be interlocked for sequential operation. The levers may be interlocked for allowing the movable power contacts to be operable (movable) when the protective earthing contacts are connected (or when the movable protective earthing contact is in an extended position) and/or the movable power contacts to be inoperable (unmovable or locked) when the protective earthing contacts are not connected (or when the movable protective earthing contact is in a retracted position).

Accordingly, a lever can operate on a complete set of movable contacts or on a specific part of them in one time. In an example, a lever or plurality of levers may be configured to operate the movable contacts in a sequence. In a sequence, the UPS system, the lever and/or the protective earthing contacts may be configured such that the protective earthing contact always connects first and disconnects last.

For example, plurality of levers can operate on a subset of movable contacts, for example first power source contacts, second power source contacts, external load contacts, protective earthing contacts. Accordingly, the protective earthing contacts may be configured to connect first and disconnect last.

Additionally, the operating lever can provide an input indicating electrical safety status to a control module to indicate that the electrically connections are securely closed and safe operation is possible.

According to embodiments, a control module of the separable uninterruptible power supply module is configured to receive a position of the lever. For example, the control module of the UPS module can be configured to provide an indicator that the UPS module is active to avoid the connections from being opened by an operator while the UPS module is in operation.

According to embodiments, the separable UPS module includes a position detector such as a microswitch. The position detector may be configured for detecting a position (e.g., retracted vs. extended position) of at least one movable contact 350.

The separable UPS module may include a co-moving (e.g., sliding or rotating) structure. The at least one movable contact 350 may be arranged to move with the co-moving structure, for example by being rigidly connected with the co-moving structure or via a gear connecting the movable contact 350 with the co-moving structure. For example, at least one movable contact may be arranged on or connected to the sliding structure in this manner.

The position detector (e.g., microswitch) may be configured to indicate a position of the co-moving structure, and thereby a position of the at least one movable contact 350.

In an example, the position detector may be arranged to be switched to a first condition (e.g. open condition or close condition) when the co-moving structure is in a first position where the at least one movable contact 350 is in an extended position. In this or another example, the position detector may be arranged to be switched to a second condition (e.g. close condition or open condition) when the co-moving structure is in a second position where the at least one movable contact 350 is in a retracted position.

The position detector may be connected to a control module of the separable UPS module. The position detector may be configured to indicate a position of the co-moving structure, and thus a position of at least movable contact 350 to the control module.

Thus, the control module may be configured to select an operation mode (e.g., at least one of a safe and automatic operation mode), depending on the output of the position detector and thus on the indicated position of the at least one movable contact 350.

According to embodiments. at least one lever for operating the movable contacts is configured to be lockable for locking the movable contacts in the retracted position and/or in the extended position. A lever can be configured to be lockable at an access point of the lever, e.g. at the handle of the lever. Accordingly, safety can be improved.

### Connection and disconnection

For example, a single person is able to insert a UPS module into the system frame by rolling the UPS module provided with casters or similar. In the example, when the UPS module is inserted in the system frame, a contact or a plurality of contacts can be operated in some manner such as a sliding or rotating operation, to make the electrical connection.

Module removal can be achieved by reversing the insertion process. For example, after electrical shutdown of the UPS module, the electrical power contacts can be slid out or rotated out so that the module is electrically disconnected and electrically safe for operations such as servicing or removal. For example, a UPS module may be removed for replacement of the complete module or for maintenance of an internal component of the module.

Such a connection and disconnection system can additionally provide for activation and deactivation of the power connections of the UPS module independent of the insertion or removal of the UPS module. In this way, UPS modules can be electrically connected, e.g. to busbars of the system frame, by operating the lever or handle.

In this way, the electrical connection and disconnection operation can be separate from the insertion and removal operation of the UPS module into or from the receiving portion and/or system frame of the modular UPS system.

Compared to modular UPS systems where the UPS module is electrically connected to the UPS system frame as long as the UPS module is in the frame, in the embodiments described herein, the UPS module can be inserted or fixed to a UPS system frame without being electrically connected.

Electrical connection can be made by moving a handle on a lever, for example in a vertical motion or horizontal motion. The lever may then close or open the electrical contacts and the UPS module can be connected to or disconnected from the receiving portion of the modular UPS system.

### Protective earthing contacts

According to embodiments, the modular uninterruptible power supply system is configured for the first protective earthing contact and the second protective earthing contact to be electrically connected before the set of first power contacts and the set of second power contacts are electrically connected by moving the movable contacts from the retracted position to the extended position.

According to embodiments, the modular uninterruptible power supply system is configured for the first protective earthing contact and the second protective earthing contact to be still electrically connected after the set of first power contacts and the set of second power contacts are electrically separated by moving the movable contacts from the extended position to the retracted position.

For example, the first protective earthing contact and the second protective earthing contact may be fixed contacts, and may be in permanent engagement (with each other) while the power supply module is placed in or fixed to the receiving portion. The first protective earthing contact and the second protective earthing contact may be connected to each other by inserting the power supply module into the receiving portion, and may be separated from each other by removing the power supply module into the receiving portion.

Alternatively, one of the first protective earthing contact and the second protective earthing contact may be a movable protective earthing contact, and the other one may be a fixed protective earthing contact. In this case, the modular uninterruptible power supply system may be configured for the first protective earthing contact and the second protective earthing contact to be electrically connected before the set of first power contacts and the set of second power contacts are electrically connected when the movable contacts are moved from the retracted position to the extended position.

According to embodiments, the modular uninterruptible power supply system may be configured for the first protective earthing contact and the second protective earthing contact to be electrically separated after the set of first power contacts and the set of second power contacts are electrically separated when the movable contacts are moved from the extended position to the retracted position.

According to embodiments, the movable protective earthing contact may be dimensioned or moved differently from the other movable contacts. According to embodiments, the movable protective earthing contact is configured to engage earlier and/or separate later from the fixed protective earthing contact, compared to the engagement of the set of first power contacts and the set of second power contacts.

FIG. 3 shows an example of configuring the fixed contacts and movable contacts according to embodiments herein.

A plurality of fixed contacts 310 such as first fixed contact 320 and second fixed contact 330 may be for example fixed power contacts, and/or fixed contacts for connecting external load, first source of energy and/or second source of energy.

A plurality of movable contacts 350 such as first movable contact 360 and second movable contact 370 may be for example movable power contacts, and/or movable contacts for connecting external load, first source of energy and/or second source of energy.

The third fixed contact 340 may be for example the fixed protective earthing contact, and the third movable contact 380 may be for example the movable protective earthing contact.

The third fixed contact 340 may be configured to be longer than the first fixed contact 320 and second fixed contact 330 (or arranged closer to the third movable contact 380 than other fixed contacts 320, 330 to their respective movable contacts 360, 370. Accordingly, the third movable contact 380 may be configured to connect before/earlier/first or disconnect after/later/last, with the respective third fixed contact 340 as compared to other movable contacts 360, 370 with their respective fixed contacts 320, 330.

### Busbars

The modular UPS system may include busbars 220. Alternatively, modular UPS system may include electrical connections. Electrical connections may include at least one of cables and busbars 220. The electrical connections or busbars 220 may be for transferring power. Electrical connections may also be provided for control lines and/or protective earthing.

In an example, power may be transferred between a UPS module 100 and an external load 120 via busbars 220. In another example, power may be transferred between a UPS module 100 and a first source of energy 150 via busbars 220. In another example, power may be transferred between a UPS module 100 and a second source of energy 170 via busbars 220.

In another example, power may be transferred between a UPS module 100 and a distribution system via busbars 220. In another example, power, control signals, other electrical energy or information may be transferred between a UPS module 100 and another UPS module via busbars 220 or electrical connections including busbars 220.

### UPS system

A modular uninterruptible power supply system or modular UPS system may include a system frame. The system frame may include a receiving portion for receiving one or more UPS module. Accordingly, a flexible and customisable modular UPS system is provided.

According to embodiments, the modular UPS system includes a system frame. According to embodiments, the modular UPS system or the system frame includes a receiving portion for receiving a UPS module therein.

According to embodiments, the UPS module is insertable by an insertion-sliding motion into the receiving portion. According to embodiments, the UPS module is removable by a removing-sliding motion out of the receiving portion. According to embodiments, the removing sliding motion is opposite of the insertion sliding motion.

In the embodiment shown in FIG. 2, the modular UPS system includes a UPS module 100, and system frame 200. The system frame may include a receiving portion 210 for one or more UPS modules. In the embodiment shown in FIG. 2, the system frame includes a receiving portion 210 in a portion adjacent to busbars 220 or in a portion including busbars 220.

In the embodiment shown in FIG. 2, the system frame includes a frame portion 230 for customer cable landings, bypasses, static bypasses, switch gears, system user interfaces, communication means, protection means, a distributed or a common battery and so on.

According to an aspect, there is a provided a method of operating a modular uninterruptible power supply system, the modular uninterruptible power supply system including a separable uninterruptible power supply module 100 with a first plurality of electrical contacts, the first plurality of electrical contacts comprising at least a set of first power contacts 510; 550 and a first protective earthing contact 540; 580; and a system frame 200 having a receiving portion 210 for receiving the separable uninterruptible power supply module 100 therein, wherein the separable uninterruptible power supply module 100 is insertable by an insertion-sliding motion into the receiving portion 210 and removable by a removing-sliding motion out of the receiving portion 210, the removing sliding motion being opposite of the insertion sliding motion, and a second plurality of electrical contacts, the second plurality of electrical contacts comprising at least a set of second power contacts for electrically connecting with the set of first power contacts 510; 550, and a second protective earthing contact for electrically connecting with the first protective earthing contact 540; 580, wherein one of the set of first power contacts 510; 550 and the set of second power contacts are movable contacts 350, and the other one of the set of first power contacts 510; 550 and the set of second power contacts are fixed contacts 310, wherein the movable contacts 350 are movable between an extended position and a retracted position, wherein when the separable uninterruptible power supply module 100 is inserted into the receiving portion 210 and when the movable contacts 350 are in the extended position, the set of first power contacts 510, 550 are in electrical contact with the set of second power contacts, and wherein when the separable uninterruptible power supply module 100 is inserted into the receiving portion 210 and when the movable contacts 350 are in the retracted position, the set of first power contacts 510; 550 are electrically separated from the set of second power contacts, the method including: inserting 620 the separable uninterruptible power supply module 100 into the receiving portion 210 by the insertion-sliding motion and moving 640 the movable contacts 350 from the retracted position to the extended position such that the set of first power contacts 510, 550 are in electrical contact with the set of second power contacts; and/or, moving 660 the movable contacts 350 from the extended position to the retracted position such that the set of first power contacts 510; 550 are electrically separated from the set of second power contacts and removing 680 the separable uninterruptible power supply module 100 out of the receiving portion 210 by the removing-sliding motion.

In the embodiment shown in FIG. 6, a method of operating a modular uninterruptible power supply system includes at least one of: inserting 620 the separable uninterruptible power supply module 100 into the receiving portion 210 by the insertion-sliding motion and moving 640 the movable contacts 350 from the retracted position to the extended position such that the set of first power contacts 510, 550 are in electrical contact with the set of second power contacts; and, moving 660 the movable contacts 350 from the extended position to the retracted position such that the set of first power contacts 510; 550 are electrically separated from the set of second power contacts and removing 680 the separable uninterruptible power supply module 100 out of the receiving portion 210 by the removing-sliding motion.

In the embodiment shown in FIG. 7A, a method of operating a modular uninterruptible power supply system includes inserting 620 the separable uninterruptible power supply module 100 into the receiving portion 210 by the insertion-sliding motion; moving 640 the movable contacts 350 from the retracted position to the extended position such that the set of first power contacts 510, 550 are in electrical contact with the set of second power contacts; moving 660 the movable contacts 350 from the extended position to the retracted position such that the set of first power contacts 510; 550 are electrically separated from the set of second power contacts; and, removing 680 the separable uninterruptible power supply module 100 out of the receiving portion 210 by the removing-sliding motion.

In the embodiment shown in FIG. 7B, a method of operating a modular uninterruptible power supply system includes moving 660 the movable contacts 350 from the extended position to the retracted position such that the set of first power contacts 510; 550 are electrically separated from the set of second power contacts; removing 680 the separable uninterruptible power supply module 100 out of the receiving portion 210 by the removing-sliding motion; inserting 620 the separable uninterruptible power supply module 100 into the receiving portion 210 by the insertion-sliding motion; and, moving 640 the movable contacts 350 from the retracted position to the extended position such that the set of first power contacts 510, 550 are in electrical contact with the set of second power contacts.

Accordingly, a method of operating a modular UPS system is provided. In particular, it is provided a UPS module that can be handled by a single operator even when the UPS module is particularly heavy or when the connection and disconnection forces involved are particularly large.

Accordingly, a method of operating modular UPS systems with larger power ratings is provided. Accordingly, at least one of handleability, serviceability and installation of the modular UPS system is improved.

While the foregoing is directed to embodiments, other and further embodiments may be devised without departing from the basic scope, and the scope is determined by the claims that follow.

## Claims

1. A modular uninterruptible power supply system comprising:
a separable uninterruptible power supply module (100) with a first plurality of electrical contacts, the first plurality of electrical contacts comprising at least a set of first power contacts (510; 550) and a first protective earthing contact (540; 580); and
a system frame (200) having
- a receiving portion (210) for receiving the separable uninterruptible power supply module (100) therein, wherein the separable uninterruptible power supply module (100) is insertable by an insertion-sliding motion into the receiving portion (210) and removable by a removing-sliding motion out of the receiving portion (210), the removing sliding motion being opposite of the insertion sliding motion, and
- a second plurality of electrical contacts, the second plurality of electrical contacts comprising at least a set of second power contacts for electrically connecting with the set of first power contacts (510; 550), and a second protective earthing contact for electrically connecting with the first protective earthing contact (540; 580),
wherein one of the set of first power contacts (510; 550) and the set of second power contacts are movable contacts (350), and the other one of the set of first power contacts (510; 550) and the set of second power contacts are fixed contacts (310),
wherein the movable contacts (350) are movable between an extended position and a retracted position,
wherein when the separable uninterruptible power supply module (100) is inserted into the receiving portion (210) and when the movable contacts (350) are in the extended position, the set of first power contacts (510, 550) are in electrical contact with the set of second power contacts, and
wherein when the separable uninterruptible power supply module (100) is inserted into the receiving portion (210) and when the movable contacts (350) are in the retracted position, the set of first power contacts (510; 550) are electrically separated from the set of second power contacts.

2. The modular uninterruptible power supply system according to claim 1, wherein the movable contacts (350) are configured to be operable by a lever (420; 440; 520; 560) for moving the movable contacts (350) between the retracted and the extended position.

3. The modular uninterruptible power supply system according to claim 1 or claim 2, wherein the separable uninterruptible power supply module (100) includes a first source of energy (150), preferably wherein the first source of energy (150) is a battery system.

4. The modular uninterruptible power supply system according to any of claims 1 to 3, wherein the system frame has fixed busbars (220) for transferring power between the separable uninterruptible power supply module (100) and an external load (120) and/or a second source of energy (170), via the set of first power contacts (510; 550) and the set of second power contacts first, preferably wherein the external load (120) and/or the second source of energy (170) is single phase AC or multiphase AC, and/or two or more pole DC.

5. The modular uninterruptible power supply system according to any of claims 1 to 4, wherein the modular uninterruptible power supply system is configured for the first protective earthing contact (540; 580) and the second protective earthing contact to be electrically connected before the set of first power contacts (510; 550) and the set of second power contacts are electrically connected preferably by moving the movable contacts (350) from the retracted position to the extended position, and/or
wherein the modular uninterruptible power supply system is configured for the first protective earthing contact (540; 580) and the second protective earthing contact to be still electrically connected after the set of first power contacts (510; 550) and the set of second power contacts are electrically separated by moving the movable contacts from the extended position to the retracted position.

6. The modular uninterruptible power supply system according to any of claims 1 to 5, wherein the separable uninterruptible power supply module includes a first converter (110) for transferring power from an internal DC link (130) of the separable uninterruptible power supply module (100) to an external load (120).

7. The modular uninterruptible power supply system according to any of claims 1 to 6, wherein the separable uninterruptible power supply module (100) includes a second converter (140) for transferring power between a first source of energy (150) and an internal DC link (130) of the separable uninterruptible power supply module (100).

8. The modular uninterruptible power supply system according to any of claims 1 to 7, wherein the separable uninterruptible power supply module (100) includes a third converter (160) for transferring power between a second source of energy (170) and an internal DC link (130) of the separable uninterruptible power supply module (100) for enabling the separable uninterruptible power supply module (100) to act as an online uninterruptible power supply.

9. The modular uninterruptible power supply system according to any of claims 1 to 8, wherein the movable contacts (350) are operable by a single lever (420; 440; 520; 560) which preferably also operates at least one movable control and communication contact connected to a control module of the separable UPS module.

10. The modular uninterruptible power supply system according to any of claims 1 to 8, wherein the movable protective earthing contact is operable by a first lever and the movable power contacts (510; 550) are operable by at least a second lever, preferably wherein at least one movable control and communication contact connected to a control module of the separable UPS module is operable by a third lever.

11. The modular uninterruptible power supply system according to any of claims 1 to 10, wherein the movable contacts (350) and/or the fixed contacts (310) are self-aligning and/or blind mateable.

12. The modular uninterruptible power supply system according to any of claims 1 to 11, wherein the separable uninterruptible power supply module (100) are on castors and/or wherein the system frame (200) includes a controllable bypass switch connecting a second source of energy (170) and/or an AC supply to an external load (120).

13. The modular uninterruptible power supply system according to any of claims 1 to 12, wherein a control module of the separable uninterruptible power supply module is configured to receive a position of a lever (420; 440; 520; 560), the lever being for operating at least one of the movable contacts (350), and/or a lever or levers is configured for providing an input to a control module of the separable UPS module indicating respective movable contacts are in a retracted position.

14. The modular uninterruptible power supply system according to any of claims 1 to 13, wherein a lever or levers (420; 440; 520; 560) for operating the movable contacts (350) is configured to be lockable for locking the movable contacts (350) in the retracted position and/or in the extended position.

15. A method of operating a modular uninterruptible power supply system, the modular uninterruptible power supply system including:
a separable uninterruptible power supply module (100) with a first plurality of electrical contacts, the first plurality of electrical contacts comprising at least a set of first power contacts (510; 550) and a first protective earthing contact (540; 580); and
a system frame (200) having
- a receiving portion (210) for receiving the separable uninterruptible power supply module (100) therein, wherein the separable uninterruptible power supply module (100) is insertable by an insertion-sliding motion into the receiving portion (210) and removable by a removing-sliding motion out of the receiving portion (210), the removing sliding motion being opposite of the insertion sliding motion, and
- a second plurality of electrical contacts, the second plurality of electrical contacts comprising at least a set of second power contacts for electrically connecting with the set of first power contacts (510; 550), and a second protective earthing contact for electrically connecting with the first protective earthing contact (540; 580),
wherein one of the set of first power contacts (510; 550) and the set of second power contacts are movable contacts (350), and the other one of the set of first power contacts (510; 550) and the set of second power contacts are fixed contacts (310),
wherein the movable contacts (350) are movable between an extended position and a retracted position,
wherein when the separable uninterruptible power supply module (100) is inserted into the receiving portion (210) and when the movable contacts (350) are in the extended position, the set of first power contacts (510, 550) are in electrical contact with the set of second power contacts, and
wherein when the separable uninterruptible power supply module (100) is inserted into the receiving portion (210) and when the movable contacts (350) are in the retracted position, the set of first power contacts (510; 550) are electrically separated from the set of second power contacts,
the method comprising:
inserting (620) the separable uninterruptible power supply module (100) into the receiving portion (210) by the insertion-sliding motion and moving (640) the movable contacts (350) from the retracted position to the extended position such that the set of first power contacts (510, 550) are in electrical contact with the set of second power contacts, and/or
moving (660) the movable contacts (350) from the extended position to the retracted position such that the set of first power contacts (510; 550) are electrically separated from the set of second power contacts and removing (680) the separable uninterruptible power supply module (100) out of the receiving portion (210) by the removing-sliding motion.
